Europäisches Patentamt

**European Patent Office**

Office européen des brevets

(11) Publication number: **0 040 552**
**A1**

# (12) EUROPEAN PATENT APPLICATION

(21) Application number: **81302246.4**

(22) Date of filing: **20.05.81**

(51) Int. Cl.³: **H 01 L 23/36**
**C 04 B 35/58**

(30) Priority: **20.05.80 ZA 803000**

(43) Date of publication of application:
**25.11.81 Bulletin 81/47**

(84) Designated Contracting States:
**BE DE GB NL**

(71) Applicant: **DE BEERS INDUSTRIAL DIAMOND DIVISION (PROPRIETARY) LIMITED**
**8th Floor 45 Main Street**
**Johannesburg Transvaal(ZA)**

(72) Inventor: **Caveney, Robert John**
**57 Victoria Avenue Sandringham**
**Johannesburg Transvaal(ZA)**

(74) Representative: **Ellis-Jones, Patrick George Armine et al,**
**J.A. KEMP & CO. 14 South Square Gray's Inn**
**London WC1R 5EU(GB)**

(54) **Heat sinks.**

(57) This invention concerns the mounting of small electronic devices on heat sinks. The heat sink comprises a cubic boron nitride compact which has a second ceramic phase and is therefore essentially electrically insulating. The cubic boron nitride compact may provide the heat sink as such or it may be mounted on a body of copper or similar metal of good heat conductivity in which case the heat sink comprises a combination of the compact and the body.

Croydon Printing Company Ltd.

EP 0 040 552 A1

- 1 -

DESCRIPTION

·HEAT SINKS

This invention relates to heat sinks.

Small electronic devices are usually mounted on a much larger block of a metal of good heat conductivity such as copper which acts as a heat sink for conducting heat away from the device as quickly as possible. It is desirable, particularly for many small high-power devices such as junction lasers, Gunn diodes or Impatt diodes, to provide a rapid heat conduction away from the device. To achieve rapid heat conduction the electronic devices may be mounted on diamonds which are then placed in thermal contact with a larger body of metal of good heat conductivity. Heat sinks of this configuration are described, for example, in British Patent Specification number 1,393,934.

It has now been found that cubic boron nitride abrasive compacts which consist of a mass of cubic boron nitride particles and a second ceramic phase bonded into a hard conglomerate can be used to replace diamond in heat sinks of the type described above. Thus, the invention provides according to one aspect, a heat sink comprising a body of metal of good heat conductivity and a cubic boron nitride compact in thermal contact with the body, the compact consisting of a mass of cubic boron nitride particles and a second ceramic phase bonded into a hard conglomerate and presenting a surface on which an electronic device can be mounted.

While the cubic boron nitride compact will generally be mounted on a body of metal of good heat conductivity, the compacts may be used as such as heat sinks. Thus, according to this aspect of the invention, there is provided an electronic device mounted on a cubic boron nitride compact consisting of a mass of cubic boron nitride particles and a second ceramic phase bonded into a hard conglomerate.

The abrasive compact is a cubic boron nitride compact which contains a ceramic second phase. Such compacts are known in the art. An example of such a compact is one wherein the second phase consists of a boride, nitride, oxide or silicide refractory, preferably silicon nitride and a hard ceramic resulting from the interaction of a catalyst metal and the refractory. These compacts are described and claimed in British Patent No 1,456,765.

Another example of a suitable compact is that described in British Patent Publication No 2 048 927. In this compact the cubic boron nitride particles are bonded with a second phase consisting essentially of aluminium, nitride and/or diboride.

In heat sinks it is desirable that the portion in contact with the electronic device is electrically insulating. The cubic boron nitride compacts of the type used in this invention offer the material advantage that they are electrically insulating because the second phase is a ceramic and is free or substantially free of any metal. Furthermore, these cubic boron nitride compacts have very satisfactory thermal conductivity properties and can be made much larger than diamond particles which are currently used commercially in heat sinks.

Cubic boron nitride compacts are usually produced in disc form. As such, they present major flat surfaces on each of opposite sides thereof. In use a compact will generally be mounted on the metal body with one flat surface in contact with the body and the other surface being available for carrying the electronic device. The compact may be mounted on a flat surface of the body or in a recess formed in the body. While the compacts used will frequently be circular in plan they may have any other desired shape such as rectangular, square or triangular in plan.

The flat surfaces of the compact may be polished to improve further the heat conduction away from the electronic device in use. Polishing of the flat surfaces may be achieved by methods known in the art using a standard polishing scaife.

The metal body, when provided, will generally be larger than the cubic boron nitride compact. The metal may be any metal of good heat conductivity known in the art, but is preferably copper.

The mounting of the electronic device on a surface of the compact may be achieved using methods well known in the art.

An embodiment of the invention will now be described with reference to the accompanying drawing in which:

Figure 1 is a side view partially sectioned of a heat sink of the invention, and

Figure 2 is a plan view of the heat sink of Figure 1.

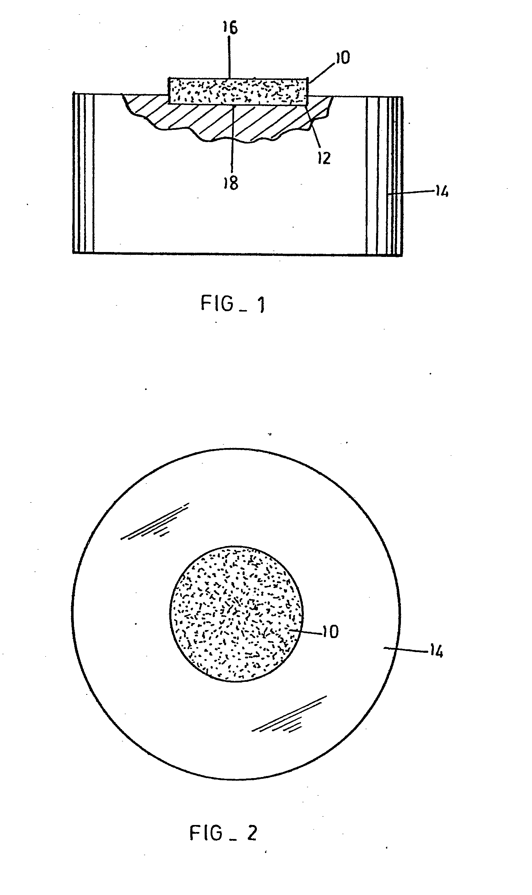

Referring to the drawings, there is shown a heat sink consisting of a cubic boron nitride compact 10 mounted in a recess 12 in a larger body of copper 14. As can be seen from Figure 2 both the body and cubic boron nitride compact are circular in plan.

The cubic boron nitride compact is in the form of a disc having two major flat surfaces 16, 18. The surface 18 is in thermal contact with the copper body 14 while the surface 16 is one on which an electronic device can be mounted.

The cubic boron nitride compact is preferably of the type described in British Patent Publication No 2 048 927, that is compact wherein the second phase consists essentially of aluminium nitride and/or diboride. These compacts can be produced in sizes much larger and at a price which is more competitive than natural diamonds which are currently used commercially in heat sinks.

CLAIMS

1. A heat sink comprising a metal body of good heat conductivity and a cubic boron nitride compact in thermal contact with the body, the compact comprising a mass of cubic boron nitride particles and a second ceramic phase bonded into a hard conglomerate and presenting a surface on which an electronic device can be mounted.

2. A heat sink according to claim 1 in which the compact presents major flat surfaces on each of the opposite sides thereof, one surface being in thermal contact with the body and the other surface being available for carrying an electronic device.

3. A heat sink according to claim 2 in which the flat surfaces are polished.

4. A heat sink according to any one of the preceding claims wherein the second phase consists essentially of aluminium nitride and/or boride.

5. An electronic device mounted on a heat sink as claimed in any one of claims 1 to 4.

6. An electronic device mounted on a surface of a cubic boron nitride compact comprising a mass of cubic boron nitride particles and a second ceramic phase bonded into a hard conglomerate.

7. An electronic device according to claim 6 mounted on a major flat surface of the compact, said compact having a second flat surface on the opposite side from the said major flat surface.

8. An electronic device according to claim 7 in which the flat surfaces are polished.

9. An electronic device according to any one of claims 6 to 8 in which the second phase comprises aluminium nitride and/or boride.

FIG _ 1

FIG _ 2

0040552

Application number

EP 81 30 2246.4

European Patent Office

**EUROPEAN SEARCH REPORT**

## DOCUMENTS CONSIDERED TO BE RELEVANT

| Category | Citation of document with indication, where appropriate, of relevant passages | Relevant to claim |
|---|---|---|
| X | Patents Abstracts of Japan Vol. 2, No. 149, 13 December 1978, page 9481E78 & JP - A - 53 - 117386 | |
| | US - A - 4 188 194 (GENERAL ELECTRIC CO.) * claim 1; column 4, line 51 to column 5, line 11; column 10, lines 43 to 55; column 22, lines 36 to 44; fig. 18 * | 1,2 |
| D,P | GB- A - 2 048 927 (DE BEERS) * claim 1; page 2, lines 33 to 49; page 3, lines 76 to 83 * | 1,4 |
| D | GB - A - 1 456 765 (DE BEERS) * claims 1, 5; page 1, lines 35 to 97 * | 1,4 |
| A | US - A - 4 110 084 (GENERAL ELECTRIC CO.) * claim 1; column 8, line 65 to column 9, line 35 * | |

### CLASSIFICATION OF THE APPLICATION (Int. Cl.³)

H 01 L 23/36
C 04 B 35/58

### TECHNICAL FIELDS SEARCHED (Int. Cl.³)

C 04 B 35/58
H 01 L 23/36

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X The present search report has been drawn up for all claims

| Place of search | Date of completion of the search | Examiner |
|---|---|---|
| Berlin | 18-08-1981 | GIBBS |

EPO Form 1503.1   06.78